# EUROPÄISCHE PATENTSCHRIFT

(11) **EP 0 478 998 B1**
(45) Veröffentlichungstag und Bekanntmachung des Hinweises auf die Patenterteilung: **26.04.1995**
(21) Anmeldenummer: 91115293.2
(22) Anmeldetag: 10.09.1991
(51) Int. Cl.: H01L 41/08, H01L 41/24

(54) **Herstellverfahren für einen Piezoantrieb**
Method of making a piezoelectric actuator
Procédé de fabrication d'un organe d'actionnement piezoélectrique

(30) Priorität: 05.10.1990 DE 4031623
(43) Veröffentlichungstag der Anmeldung: 08.04.1992
(73) Patentinhaber: SIEMENS AKTIENGESELLSCHAFT, 80333 München (DE)
(72) Erfinder: Mohaupt, Jutta, W-8000 München 2 (DE); Lubitz, Karl, Dr., W-8012 Ottobrunn (DE); Schnöller, Manfred, Dr., W-8048 Haimhausen (DE); Wersing, Wolfram, Dipl.-Phys., W-8011 Kirchheim (DE)

(56) Entgegenhaltungen:
- EP-A- 0 292 014
- EP-A- 0 427 901
- WO-A-86/05350
- PROC. 6TH INTERNATIONAL SYMPOSIUM ON APPLICATIONS OF FERROELECTRICS,BETHLEHEM, PA, USA, 8-11. Juni 1986, Seiten 652-655 ; W. WERSING et al.: "Multilayer piezoelectric ceramic actuators"

## Beschreibung

Die Erfindung betrifft ein Herstellverfahren für einen Piezoantrieb.

Biegeelemente aus Piezokeramik und elektromechanische Antriebe auf der Basis von Piezokeramik, sogenannte Piezoantriebe, sind seit langem bekannt. Aus den für Piezokeramiken typischen Piezomodulen ergibt sich, daß auf einfache Weise nur Antriebe für hohe elektrische Spannung auch große mechanische Amplituden liefern. Antriebe zu bauen, die für große mechanische Amplituden mit niedrigen elektrischen Spannungen, wie sie im allgemeinen zur Verfügung stehen, auskommen, stellt ein erhebliches Problem dar.

Bekannte Piezoantriebe sind dabei aus möglichst dünnen Piezokeramiklamellen aufgebaut, die einzeln miteinander verklebt werden. Dabei sollte die Dicke der Einzellamelle aus Gründen der Handhabbarkeit nicht wesentlich unter 100 »m liegen. Mit solchen Piezoantrieben wird eine möglichst große Auslenkung erzielt, wenn die Ansteuerspannung soweit wie möglich erhöht wird. Eine Grenze stellt dabei eine vom Keramikmaterial abhängige Grenzfeldstärke von etwa 2 kV/mm dar. Damit ergeben sich etwa 100 bis 200 Volt Betriebsspannung. Niedrigere Betriebsspannungen lassen sich bei gegebener Auslenkung daher nur erreichen, wenn der Antrieb unnötig groß aufgebaut wird. Für viele Anwendungen ist dieses jedoch nicht möglich.

Aus der DE-OS 34 34 729 ist ein Biegeelement aus Piezokeramik bekannt, das aus einer Mehrschicht-Piezokeramik aus 10 bis 20 »m dicken Keramikschichten mit eingesinterten Platinelektroden besteht. Damit läßt sich die Ansteuerspannung auf ein Fünftel bis ein Zehntel des obigen Wertes reduzieren.

Aus der DE-OS 34 34 729 ist des weiteren ein Herstellverfahren bekannt für das Biegeelement aus Piezokeramik, bei dem zwischen den Keramiklagen Abstandsschichten vorgesehen sind. Die Abstandsschichten bestehen aus einem Material, das aus sinterbeständigen Körnern und aus einem Füllmaterial, das im Verlauf der Durchführung der Sinterung verbrennt, zusammengesetzt ist. Die sinterbeständigen Körner weisen eine Korngrößenverteilung auf, die der vorgesehenen Schichtdicke der Abstandsschichten angepaßt ist. Nach Durchführung des Sinterprozesses entstehen durch Ausbrennen des Füllstoffes Hohlräume. Diese Hohlräume werden mit niedrig schmelzendem Metall oder elektrisch leitendem Kunststoff gefüllt. Da die Keramiklagen und die Abstandsschichten in einem Siebdruckverfahren auf einem Träger aufgebracht werden, ist dieses Verfahren auf die Herstellung von Biegeelementen beschränkt. Der Abstand zwischen benachbarten Keramikschichten ist bei diesem Herstellverfahren durch die Dicke der sinterbeständigen Körner vorgegeben. Die Korngröße in einem Pulver weist stets eine gewisse Streuung auf. Darüberhinaus ist die Geometrie der Hohlräume auch dadurch bestimmt, daß die sinterbeständigen Körner in dem Füllmaterial zufällig verteilt sind. Dadurch ergibt sich eine ungleichmäßige Größe der Hohlräume.

Aus PROC. 6TH INTERNATIONAL SYMPOSIUM ON APPLICATIONS OF FERRO-ELECTRICS; BETHLEHEM PA, USA, 8-11 JUNE 1986, Seiten 652-655, ist ein Verfahren zur Herstellung einer Vielschichtpiezokeramik bekannt bei dem Keramikrohfolien mit einer Abstandspaste in der gewünschten Elektrodenform bedruckt werden.

Der Erfindung liegt das Problem zugrunde, ein Herstellverfahren für einen Pieozantrieb anzugeben, bei dem zwischen Keramikschichten Hohlräume in einer wohl definierten und gleichmäßigen räumlichen Abmessung hergestellt werden.

Dieses Problem wird erfindungsgemäß gelöst durch ein Herstellverfahren nach Anspruch 1.

Durch die Verwendung gegossener Rohfolien zur Erzeugung des Stapels erübrigt sich die Verwendung eines Trägers, die in dem aus DE-OS 34 34 729 bekannten Verfahren zwingend erforderlich ist.

Erfindungsgemäß werden die Stützstrukturen und die Füllstrukturen dadurch erzeugt, daß die Rohfolien mit einer Photolackschicht versehen werden, die Photolackschicht durch eine Maske entsprechend einer vorbestimmten Elektrodenstruktur belichtet wird, die unbelichteten Teile der Photolackschicht abgelöst werden und die Rohfolien gestapelt und heiß verpreßt werden. Bei dem heißen Verpressen gelangen die Stellen der Rohfolien, die nicht mehr mit Lack beschichtet sind, mit der darüberliegenden Rohfolie in engen Kontakt, so daß an diesen Stellen die Keramikschichten während des Brennprozesses zusammensintern. An den mit Photolack beschichteten Stellen brennt dieser während des Brennens mit aus, wobei die gewünschten Hohlräume zwischen den Keramikschichten entstehen. Der Photolack läßt sich mit bekannten Verfahren in einer Dicke bis herab zu 1 »m gut kontrolliert auf die Keramikfolien aufbringen. Hohlräume mit einer Ausdehnung von 5 »m sind daher mit dem erfindungsgemäßen Verfahren sicher herstellbar.

Bei der Erzeugung der Stütz- und Füllstrukturen mit Hilfe von Photolack werden Hohlräume mit einer gleichmäßigen Verteilung der Stützen hergestellt.

Zur Erzeugung der Elektroden sind z. B. Metalle wie Blei, Zinn oder Kupfer geeignet, die bei einer Temperatur oberhalb ihrer Schmelztemperatur eingefüllt werden.

Es liegt ferner im Rahmen der Erfindung, die Elektroden aus einem leitenden Kunststoff herzustellen, der nach dem Einfüllen als Monomer in die Hohlräume polymerisiert wird.

Die Verwendung von leitfähigem Kunststoff als Elektrodenmaterial ist für Piezoantriebe besonders vorteilhaft, da der Elastizitätsmodul des leitfähigen Kunststoffs wesentlich niedriger ist als der von Metallen. Bei der Verwendung als Elektrode führt der leitfähige Kunststoff daher zu keiner nennenswerten mechanischen Behinderung der Auslenkung und ermöglicht daher auch die Anwendung relativ dicker Elektroden. Ein weiterer Vorteil besteht darin, daß zur Vermeidung hoher Einschaltstromspitzen es wünschenswert ist, in einem Mehrschichtpiezoantrieb ein Elektrodenmaterial zu verwenden, dessen elektrische Leitfähigkeit deutlich niedriger ist als die von Metallen. Die Leitfähigkeit in Kunststoffen kann in weiten Grenzen eingestellt werden. Daher kann in jedem Fall ein Kunststoff gefunden werden, der einerseits den Einschalt- und Ausschaltstrom begrenzt, andererseits aber trotzdem eine hinreichend schnelle Betätigung des Antriebs erlaubt. Besonders geeignet zur Verwendung als Elektrode sind daher Kunststoffe mit leitfähigen Füllern, z. B. polymere Epoxide und Silikone mit Zusätzen von Graphit, Eisencarbonyl oder feinpulvrigen Metallen, was zu einer Leitfähigkeit zwischen 10⁻⁴ und 10 (Ohm cm)⁻¹ führt. Leitfähigkeiten zwischen 10⁻¹² und 10⁻² (Ohm cm)⁻¹ werden mit konjugierten Polymeren ohne Akzeptoren, z. b. Polypyrrol oder Polyacetylen erzielt. Mit konjugierten Polymeren mit Akzeptoren, z. B. Polyacetylen + Brom oder Benzolsulfonsäure, werden Leitfähigkeiten zwischen 1 und 10³ (Ohm cm)⁻¹ erzielt.

Der leitende Kunststoff wird in flüssiger Form als Monomer mit einer bekannten Vakuumvergußmethode in die Hohlräume der Piezokeramikantriebe eingebracht. Anschließend wird in bekannter Weise polymerisiert.

Im folgenden wird die Erfindung anhand eines Ausführungsbeispiels und der Figuren näher erläutert.
- Fig. 1 bis Fig. 3: zeigt mit Photolackstrukturen versehene Keramikrohfolien.
- Fig. 4: zeigt einen Ausschnitt aus einem Stapel von mit Photolackstrukturen versehenen Rohfolien.
- Fig. 5: zeigt einen Piezoantrieb.

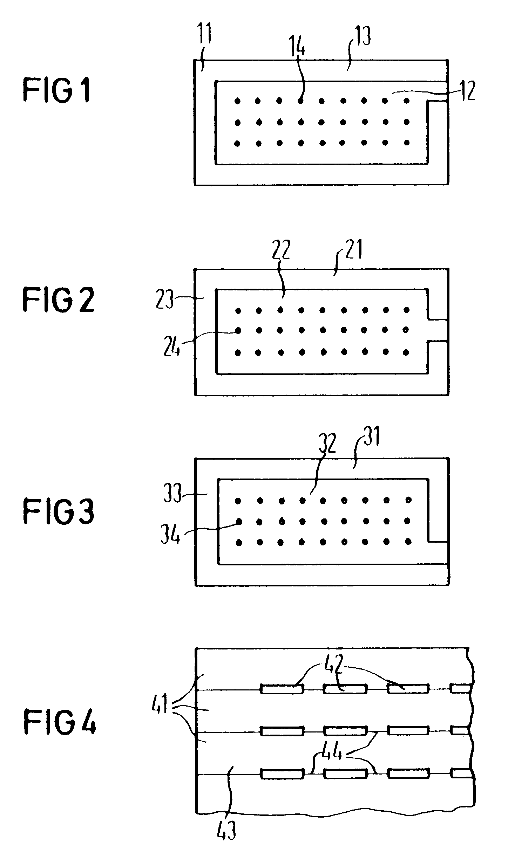

In Fig. 1 ist eine Rohfolie 11 dargestellt. Die Rohfolie 11 ist mit einer Photolackstruktur 12 versehen. Die Rohfolie 11 besteht aus einer Piezokeramik, z. B. aus dotiertem Bleizirkonattitanat. Die Photolackstruktur 12 läßt einen Rand 13 sowie Stützstrukturen 14 unbedeckt.

Die Photolackstruktur 12 wird durch Aufbringen einer Photolackschicht, anschließende Belichtung der Photolackschicht durch eine Maske und Entwicklung in bekannter Weise erzeugt.

In Fig. 2 ist eine Rohfolie 21 mit einer Photolackstruktur 22, einem Rand 23 und Stützstrukturen 24 abgebildet, die sich von der in Fig. 1 gezeigten Rohfolie 11 durch das Muster der Photolackstruktur 22 unterscheidet.

In Fig. 3 ist eine weitere Rohfolie 31 mit einer Photolackstruktur 32, einem Rand 33 und Stützstrukturen 34 dargestellt, die sich von den in Fig. 1 und Fig. 2 gezeigten Strukturen wiederum durch das Muster der Photolackstruktur 32 unterscheidet.

Zur Herstellung von Längsantrieben werden Rohfolien mit den Mustern nach Fig. 1 und Fig. 3 benötigt, für die Herstellung von Biegeantriebe werden Rohfolien aller drei Muster benötigt.

Bei der Herstellung werden im allgemeinen die benötigten Muster auf großen Folienstücken nebeneinander erzeugt. Die Folienstücke werden dann ausgestanzt, entsprechend dem gewünschten Antrieb gestapelt und warm verpreßt. Ein Ausschnitt aus dem Querschnitt eines solchen Stapels von Rohfolien 41 ist in Fig. 4 dargestellt. Zwischen den Keramikfolien 41 sind Photolackstrukturen 42 angeordnet. Beim Warmverpressen gelangen die Rohfolien im Bereich des Randes 43 sowie der Stützstellen 44 in engen Kontakt. Während des Brennprozesses kommt es zu einem Zusammensintern der Keramikschichten im Bereich des Randes 43 sowie der Stützstrukturen 44. Die Photolackstrukturen 42 brennen während des Brennprozesses aus, so daß an Stelle der Photolackstrukturen 42 feine Hohlräume zwischen den Keramikschichten entstehen.

Nach dem Brennen der Piezokeramik folgt das Aufbringen einer Boden- und Deckelektrode z. B. durch Aufdruck von Einbrennsilber, das dann bei ca. 400 - 800 °C eingebrannt wird. In demselben Schritt wird Einbrennsilber auf eine zur Boden- und Deckelektrode senkrechte Fläche, an der die Hohlräume durch den Rand der Piezokeramik hindurchreichen, nach einem vorgegebenen Muster aufgebracht. Das Muster wird so vorgegeben, daß später in den Hohlräumen herzustellende Elektroden, welche zur Polarisation der Keramikschichten elektrisch miteinander verbunden sein müssen, durch das Einbrennsilber leitend verbunden werden. Die Öffnungen, die durch das Hinausreichen der Hohlräume über den Rand gebildet werden, werden dabei so mit Einbrennsilber verschlossen, daß die Hohlräume anschließend befüllt werden können.

Danach werden die Hohlräume bei einer Temperatur über dem Schmelzpunkt des betreffenden Metalls mit z. B. Blei, Zinn oder Kupfer oder mit einem leitfähigen Kunststoff gefüllt.

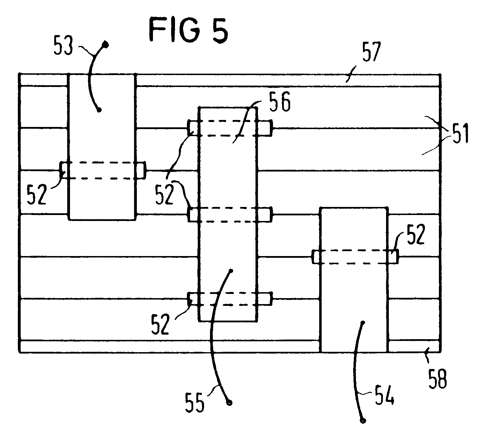

In Fig. 5 ist ein Piezoantrieb dargestellt. Der Piezoantrieb besteht aus 2 x 3 Keramikschichten 51. Zwischen den einzelnen Keramikschichten 51 sind Elektrodenstrukturen 52 angeordnet. Die Elektrodenstrukturen 52 sind durch Leitsilberflächen 56 in Gruppen zusammengefaßt jeweils mit einem der elektrischen Anschlüsse 53, 54 oder 55 verbunden.

Zur Polarisierung der Keramikschichten 51 für einen Biegeantrieb wird der Anschluß 55 mit dem Erdpotential verbunden. Der Anschluß 53 wird mit einer negativen Polungsspannung -U_{Pol}, der Anschluß 54 mit einer positiven Polungsspannung +U_{Pol} verbunden. Im Falle eines Längsantriebes werden die Anschlüsse 53 und 54 miteinander verbunden und es wird an sie die Polungsspannung angelegt.

Im Betrieb werden in jedem Fall die beiden Anschlüsse 53 und 54 miteinander verbunden.

## Patentansprüche

1. Herstellverfahren für einen Piezoantrieb mit folgenden Schritten:
a) in einem Stapel von gegossenen Rohfolien (11, 21, 31, 41) werden zwischen jeweils zwei Rohfolien (11, 21, 31, 41) Stützstrukturen (14, 24, 34, 44) aus einem ersten Material, das bei der Brenntemperatur der Piezokeramik aushärtet, und Füllstrukturen (12, 22, 32, 42) aus einem zweiten Material, das bei der Brenntemperatur der Piezokeramik ausbrennt, dadurch erzeugt, daß die Rohfolien (11, 21, 31, 41) mit einer Photolackschicht versehen werden, daß die Photolackschicht durch eine Maske entsprechend einer vorbestimmten Elektrodenstruktur belichtet wird, daß die unbelichteten Teile der Photolackschicht abgelöst werden und daß die Rohfolien (11, 21, 31, 41) gestapelt und heiß verpreßt werden,
b) bei dem Keramikbrennen des Stapels werden durch das Ausbrennen der als Füllstrukturen (12, 22, 32, 42) dienenden verbliebenen Photolackstrukturen Hohlräume erzeugt,
c) die Hohlräume werden nach dem Keramikbrennen bei einer Fülltemperatur, die geringer als die Brenntemperatur der Piezokeramik ist, mit leitfähigem Material gefüllt.

2. Herstellverfahren nach Anspruch 1,
**dadurch gekennzeichnet,** daß das leitfähige Material mindestens eines der Elemente Blei, Zinn oder Kupfer enthält.

3. Herstellverfahren nach Anspruche 1,
**dadurch gekennzeichnet,** daß das leitfähige Material einen leitenden Kunststoff enthält, der nach dem Einfüllen in die Hohlräume polymerisiert wird.

## Claims

1. Production method for a piezoelectric drive comprising the following steps:
a) generating supporting structures (14, 24, 34, 44) of a first material which is cured at the firing temperature of the piezoceramic and filling structures (12, 22, 32, 42) of a second material which is burnt out at the firing temperature of the piezoceramic, in a stack of cast raw films (11, 21, 31, 41) between in each case two raw films (11, 21, 31, 41), by applying a photoresist layer to the raw films (11, 21, 31, 41), by exposing the photoresist layer through a mask corresponding to a predetermined electrode structure, by removing the unexposed parts of the photoresist layer and by stacking and hot-pressing the raw films (11, 21, 31, 41),
b) generating hollow spaces during the ceramic-firing of the stack by burning out the remaining photo-resist structures which serve as filling structures (12, 22, 32, 42),
c) filling the hollow spaces with a conductive material at a filling temperature which is lower than the firing temperature of the piezoceramic, after the ceramic-firing.

2. Production method according to Claim 1, characterized in that the conductive material comprises at least one of the elements lead, tin or copper.

3. Production method according to Claim 1, characterized in that the conductive material comprises a conductive plastic which is polymerized after being filled into the hollow spaces.

## Revendications

1. Procédé de fabrication d'un organe d'entraînement piézoélectrique comportant les étapes suivantes :
a) dans une pile de lamelles brutes moulées (11, 21, 31, 41), on produit, respectivement entre deux lamelles brutes (11, 21, 31, 41), des structures-supports (14, 24, 34, 44) en un premier matériau qui durcit à la température de cuisson de la céramique piézoélectrique ainsi que des structures de remplissage (12, 22, 32, 42) en un second matériau qui se consume à la température de cuisson de la céramique piézoélectrique, ceci en munissant les lamelles brutes (11, 21, 31, 41) d'une couche de laque photosensible, en exposant à la lumière la couche de vernis photosensible à travers un cache correspondant à une structure d'électrodes donnée, en détachant les parties de la couche de vernis photosensible non exposées et en empilant et en comprimant à chaud les lamelles brutes (11, 21, 31, 41),
b) lors de la cuisson de la céramique de la pile, des cavités sont créées par le fait que des structures de vernis photosensible qui ont subsisté et qui servent de structures de remplissage (12, 22, 32, 42) se sont consumées,
c) après la cuisson de la céramique, les cavités sont emplies d'un matériau conducteur à une température de remplissage, qui est inférieure à la température de cuisson de la céramique piézoélectrique.

2. Procédé de fabrication selon la revendication 1,
caractérisé en ce que le matériau conducteur contient au moins l'un des trois éléments suivants: plomb, étain ou cuivre.

3. Procédé de fabrication selon la revendication 1,
caractérisé en ce que le matériau conducteur contient une matière plastique conductrice que l'on polymérise après que l'on en a empli les cavités.
